# EUROPÄISCHE PATENTSCHRIFT

(11) **EP 2 423 163 B1**
(45) Veröffentlichungstag und Bekanntmachung des Hinweises auf die Patenterteilung: **23.04.2014**
(21) Anmeldenummer: 11178284.3
(22) Anmeldetag: 22.08.2011
(51) Int. Cl.: C01B 33/037

(54) **Polykristallines Silicium und Verfahren zu dessen Herstellung**
Polycrystalline silicon and method for production thereof
Silicium polycristallin et son procédé de fabrication

(30) Priorität: 25.08.2010 DE 102010039752
(43) Veröffentlichungstag der Anmeldung: 29.02.2012
(73) Patentinhaber: Wacker Chemie AG, 81737 München (DE)
(72) Erfinder: Pech, Dr. Reiner, 84524 Neuötting (DE); Dornberger, Dr. Erich, 84489 Burghausen (DE)
(74) Vertreter: Killinger, Andreas

(56) Entgegenhaltungen:
- EP-A1- 1 754 539
- EP-A1- 1 876 143
- EP-A2- 1 338 682
- DE-A1-102006 035 081

## Beschreibung

Die Erfindung betrifft polykristallines Silicium und ein Verfahren zu dessen Herstellung.

Polykristallines Silicium, kurz Polysilicium, wird heute in großen Mengen industriell hergestellt und dient unter anderem als Rohstoff für Anwendungen in der Photovoltaik und für die Herstellungen von Einkristallen bei Waferherstellern. Bei allen Anwendungen wird eine hohe Reinheit des Rohstoffes gewünscht.

Bei der Herstellung von Polysilicium ist es nach der Abscheidung aus der Gasphase nötig, die Polysiliciumstäbe in kleine Stücke zur Weiterverarbeitung zu brechen. Dabei wird das hochreine Silicium aber durch den Einsatz von Bruchwerkzeugen mehr oder weniger mit Fremdatomen kontaminiert. Außerdem entstehen Siliciumstaubpartikel, die an den Bruchstücken haften.

Üblicherweise wird der Siliciumbruch für höherwertige Anwendungsbereiche wie z.B. für das Einkristallziehen vor der Weiterverarbeitung und/oder der Verpackung gereinigt. Dies geschieht nach dem Stand der Technik in einem oder mehreren chemischen Nassreinigungsschritten. Dabei kommen Mischungen aus verschiedenen Chemikalien und/oder Säuren zum Einsatz, um insbesondere anhaftende Fremdatome von der Oberfläche wieder zu entfernen. Diese Verfahren sind jedoch aufwändig und teuer.

Aus US 6,916,657 ist bekannt, dass Fremdpartikel bzw. Fremdatome die Ausbeute beim Kristallziehen reduzieren können. Auch der anhaftende Siliciumstaub könnte diesbezüglich einen negativen Einfluss haben.

Aus der Zeitschrift "Reinraumtechnik" (1/2006, "Hochreiner Siliziumstaub als Kontaminationsquelle"; Reinraumtechnik 1/2006, Ivo Crößmann) ist ein Verfahren zur Bestimmung von Siliciumstaub auf Polysilicium bekannt. Darin wird dessen negativer Einfluss bei der Weiterverarbeitung zu Einkristallen erwähnt. Es wird offenbart, dass nasschemisch gereinigtes Polysilicium "Staub"-Werte von etwa 10 ppmw und nach Transport bis zu 60 ppmw bei einer Staubpartikel-Größenverteilung von kleiner als 5 µm aufweist.

Aus WO-2009/09003688 ist ein Verfahren zur Aufbereitung von in einem Materialgemisch vorhandenem, oberflächenverunreinigten Siliciummaterial mit einer Oberflächenverunreinigung von 1 ppb bis 1000 ppm bezogen auf das Gewicht von Silicium, durch Absieben des an der Oberfläche anhaftenden Materials, bekannt. Durch das Absieben entsteht jedoch keine Reduzierung von anhaftendem Si-Staub kleiner ca. 50 µm, sondern vorwiegend nur eine Abtrennung von losen und größeren Partikeln.

Aus US 2003/0159647 A1 ist ein Verfahren zur Verarbeitung von Siliciumbruch bekannt, bei dem ein Staubentfernungssystem vorsieht, die Siliciumstücke mittels eines Luftstroms durch eine perforierte Platte von Staub zu befreien. Es wird von niedrigen Staubwerten berichtet, ohne auf Details einzugehen.

Allerdings ist die Entstaubung durch Luftstrom insbesondere für oberflächlich stark anhaftende, kleine Si-Partikel (< 50µm) wenig effizient. Kleine Si-Bruchstücke können dem Luftstrahl ausweichen. Im ungünstigsten Fall kann durch die starke Bewegung der Polysilicium-Bruchstücke in der Wirbelschicht sogar eine Partikelmehrung auftreten.

Die Aufgabe der vorliegenden Erfindung bestand darin, kostengünstiges polykristallines Silicium mit einem niedrigen Gehalt an Oberflächenstaub bereit zu stellen.

Die Aufgabe der Erfindung wird gelöst durch polykristallines Silicium einer ersten Bruchgröße, enthaltend polykristalline Siliciumbruchstücke, wobei mindestens 90% der Bruchstücke eine Größe von 10 bis 40 mm aufweisen, gekennzeichnet durch Anteile an Siliciumstaubpartikeln von kleiner als 15 ppmw für Partikelgrößen von kleiner als 400 µm, von kleiner als 14 ppmw für Partikelgrößen von kleiner als 50 µm, von kleiner als 10 ppmw für Partikelgrößen von kleiner als 10 µm und von kleiner als 3 ppmw für Partikelgrößen von kleiner als 1 µm, und weiterhin gekennzeichnet durch Oberflächenverunreinigungen mit Metallen von größer oder gleich 0,1 ppbw und kleiner oder gleich 100 ppbw.

Vorzugweise beträgt in jenem polykristallinen Silicium einer ersten Bruchgröße der Anteil an Siliciumstaubpartikeln für Partikelgrößen von kleiner als 400 µm weniger als 10 ppmw. Ganz besonders bevorzugt beträgt der Anteil an Siliciumstaubpartikeln für Partikelgrößen von kleiner als 400 µm weniger als 5 ppmw.

Vorzugweise beträgt der Anteil an Siliciumstaubpartikeln für Partikelgrößen von kleiner als 50 µm weniger als 10 ppmw. Ganz besonders bevorzugt beträgt der Anteil an Siliciumstaubpartikeln für Partikelgrößen von kleiner als 50 µm weniger als 3 ppmw.

Vorzugweise beträgt der Anteil an Siliciumstaubpartikeln für Partikelgrößen von kleiner als 10 µm weniger als 5 ppmw. Ganz besonders bevorzugt beträgt der Anteil an Siliciumstaubpartikeln für Partikelgrößen von kleiner als 10 µm weniger als 1 ppmw.

Vorzugweise beträgt der Anteil an Siliciumstaubpartikeln für Partikelgrößen von kleiner als 1 µm weniger als 1 ppmw. Ganz besonders bevorzugt beträgt der Anteil an Siliciumstaubpartikeln für Partikelgrößen von kleiner als 1 µm weniger als 0,1 ppmw.

Die genannten bevorzugten und ganz besonders bevorzugten Anteile an Siliciumstaubpartikeln des erfindungsgemäßen polykristallinen Siliciums einer ersten Bruchgröße werden vorzugsweise mit folgenden bevorzugten Oberflächenverunreinigungen mit Metallen kombiniert:
Vorzugsweise betragen die Oberflächenverunreinigungen mit Metallen größer oder gleich 2, 5 ppbw und kleiner oder gleich 100 ppbw.
Vorzugsweise betragen die Oberflächenverunreinigungen mit Metallen größer oder gleich 0,6 ppbw und kleiner oder gleich 2,5 ppbw.
Vorzugsweise betragen die Oberflächenverunreinigungen mit Metallen größer oder gleich 0, 1 ppbw und kleiner oder gleich 0,6 ppbw.

Die Metalle der Oberflächenverunreinigungen des erfindungsgemäßen polykristallinen Silicium beinhalten vorzugsweise Fe, Cr, Ni, Na, Zn, Al, Cu, Mg, Ti, W, K, Co und Ca. Andere MeLalle, wie Mn und Ag, liegen in vernachlässigbar kleinen Konzentrationen vor.

Vorzugsweise beträgt die Oberflächenverunreinigung mit Eisen größer oder gleich 0, 01 ppbw und kleiner oder gleich 50 ppbw. Vorzugsweise beträgt die Oberflächenverunreinigung mit Eisen größer oder gleich 0,5 ppbw und kleiner oder gleich 50 ppbw. Vorzugsweise beträgt die Oberflächenverunreinigung mit Eisen größer oder gleich 0,1 ppbw und kleiner oder gleich 0,5 ppbw. Vorzugsweise beträgt die Oberflächenverunreinigung mit. Eisen größer oder gleich 0,01 ppbw und kleiner oder gleich 0, 1 ppbw.

Vorzugsweise beträgt die Oberflachenverunreinigung mit Wolfram größer oder gleich 0,01 ppbw und kleiner oder gleich 50 ppbw. Vorzugsweise beträgt die Oberflächenverunreinigung mit Wolfram größer oder gleich 1 ppbw und kleiner oder gleich 50 ppbw. Vorzugsweise beträgt die Oberflächenverunreinigung mit Wolfram größer oder gleich 0,1 ppbw und kleiner oder gleich 1 ppbw. Vorzugsweise beträgt die Oberflächenverunreinigung mit Wolfram größer oder gleich 0,01 ppbw und kleiner oder gleich 0,1 ppbw.

Weiterhin wird die Aufgabe der Erfindung gelöst durch polykristallines Silicium einer zweiten Bruchgröße, enthaltend polykristalline Siliciumbruchstücke, wobei mindestens 90% der Bruchstücke eine Größe von 20 bis 60 mm aufweisen, gekennzeichnet durch Anteile an Siliciumstaubpartikeln von kleiner als 15 ppmw für Partikelgrößen von kleiner als 400 µm, von kleiner als 14 ppmw für Partikelgrößen von kleiner als 50 µm, von kleiner als 10 ppmw für Partikelgrößen von kleiner als 10 µm und von kleiner als 3 ppmw für Partikelgrößen von kleiner als 1 µm, und weiterhin gekennzeichnet durch Oberflächenverunreinigungen mit Metallen von größer oder gleich 0,1 ppbw und kleiner oder gleich 100 ppbw.

Vorzugweise beträgt der Anteil an Siliciumstaubpartikeln im polykristallinen Silicium dieser zweiten Bruchgröße für Partikelgrößen von kleiner als 400 µm weniger als 10 ppmw. Ganz besonders bevorzugt beträgt der Anteil an Siliciumstaubpartikeln für Partikelgrößen von kleiner als 400 µm weniger als 5 ppmw.

Vorzugweise beträgt der Anteil an Siliciumstaubpartikeln für Partikelgrößen von kleiner als 50 µm weniger als 10 ppmw. Ganz besonders bevorzugt beträgt der Anteil an Siliciumstaubpartikeln für Partikelgrößen von kleiner als 50 µm weniger als 3 ppmw.

Vorzugweise beträgt der Anteil an Siliciumstaubpartikeln für Partikelgrößen von kleiner als 10 µm weniger als 5 ppmw. Ganz besonders bevorzugt beträgt der Anteil an Siliciumstaubpartikeln für Partikelgrößen von kleiner als 10 µm weniger als 1 ppmw.

Vorzugweise beträgt der Anteil an Siliciumstaubpartikeln für Partikelgrößen von kleiner als 1 µm weniger als 1 ppmw. Ganz besonders bevorzugt beträgt der Anteil an Siliciumstaubpartikeln für Partikelgrößen von kleiner als 1 µm weniger als 0,1 ppmw.

Die genannten bevorzugten und ganz besonders bevorzugten Anteile an Siliciumstaubpartikeln des erfindungsgemäßen polykristallinen Siliciums einer zweiten Bruchgröße werden vorzugsweise mit folgenden bevorzugten Oberflächenverunreinigungen mit Metallen kombiniert:

Vorzugsweise betragen die Oberflächenverunreinigungen mit Metallen größer oder gleich 2,0 ppbw und kleiner oder gleich 100 ppbw. Vorzugsweise betragen die Oberflächenverunreinigungen mit Metallen größer oder gleich 0,5 ppbw und kleiner oder gleich 2,0 ppbw. Vorzugsweise betragen die Oberflächenverunreinigungen mit Metallen größer oder gleich 0,1 ppbw und kleiner oder gleich 0,5 ppbw.

Die Metalle der Oberflächenverunreinigungen des erfindungsgemäßen polykristallinen Silicium beinhalten vorzugsweise Fe, Cr, Ni, Na, Zn, Al, Cu, Mg, Ti, W, K, Co und Ca. Andere Metalle, wie Mn und Ag, liegen in vernachlässigbar kleinen Konzentrationen vor.

Vorzugsweise beträgt die Oberflächenverunreinigung mit Eisen größer oder gleich 0,01 ppbw und kleiner oder gleich 50 ppbw. Vorzugsweise beträgt die Oberflächenverunreinigung mit Eisen größer oder gleich 0,5 ppbw und kleiner oder gleich 50 ppbw. Vorzugsweise beträgt die Oberflächenverunreinigung mit Eisen größer oder gleich 0,1 ppbw und kleiner oder gleich 0,5 ppbw. Vorzugsweise beträgt die Oberflächenverunreinigung mit Eisen größer oder gleich 0,01 ppbw und kleiner oder gleich 0,1 ppbw.

Vorzugsweise beträgt die Oberflächenverunreinigung mit Wolfram größer oder gleich 0,01 ppbw und kleiner oder gleich 50 ppbw. Vorzugsweise beträgt die Oberflächenverunreinigung mit Wolfram größer oder gleich 1 ppbw und kleiner oder gleich 50 ppbw. Vorzugsweise beträgt die Oberflächenverunreinigung mit Wolfram größer oder gleich 0,1 ppbw und kleiner oder gleich 1 ppbw. Vorzugsweise beträgt die Oberflächenverunreinigung mit Wolfram größer oder gleich 0,01 ppbw und kleiner oder gleich 0,1 ppbw.

Weiterhin wird die Aufgabe der Erfindung gelöst durch polykristallines Silicium einer dritten Bruchgröße, enthaltend polykristalline Siliciumbruchstücke, wobei mindestens 90% der Bruchstücke eine Größe von größer als 45 mm aufweisen, gekennzeichnet durch Anteile an Siliciumstaubpartikeln von kleiner als 15 ppmw für Partikelgrößen von kleiner als 400 µm, von kleiner als 14 ppmw für Partikelgrößen von kleiner als 50 µm, von kleiner als 10 ppmw für Partikelgrößen von kleiner als 10 µm und von kleiner als 3 ppmw für Partikelgrößen von kleiner als 1 µm, und weiterhin gekennzeichnet durch Oberflächenverunreinigungen mit Metallen von größer oder gleich 0,1 ppbw und kleiner oder gleich 100 ppbw.

Vorzugweise beträgt der Anteil an Siliciumstaubpartikeln im polykristallinen Silicium dieser dritten Bruchgröße für Partikelgrößen von kleiner als 400 µm weniger als 10 ppmw. Ganz besonders bevorzugt beträgt der Anteil an Siliciumstaubpartikeln für Partikelgrößen von kleiner als 400 µm weniger als 5 ppmw.

Vorzugweise beträgt der Anteil an Siliciumstaubpartikeln für Partikelgrößen von kleiner als 50 µm weniger als 10 ppmw. Ganz besonders bevorzugt beträgt der Anteil an Siliciumstaubpartikeln für Partikelgrößen von kleiner als 50 µm weniger als 3 ppmw.

Vorzugweise beträgt der Anteil an Siliciumstaubpartikeln für Partikelgrößen von kleiner als 10 µm weniger als 5 ppmw. Ganz besonders bevorzugt beträgt der Anteil an Siliciumstaubpartikeln für Partikelgrößen von kleiner als 10 µm weniger als 1 ppmw.

Vorzugweise beträgt der Anteil an Siliciumstaubpartikeln für Partikelgrößen von kleiner als 1 µm weniger als 1 ppmw. Ganz besonders bevorzugt beträgt der Anteil an Siliciumstaubpartikeln für Partikelgrößen von kleiner als 1 µm weniger als 0,1 ppmw.

Die genannten bevorzugten und ganz besonders bevorzugten Anteile an Siliciumstaubpartikeln des erfindungsgemäßen polykristallinen Siliciums einer dritten Bruchgröße werden vorzugsweise mit folgenden bevorzugten Oberflächenverunreinigungen mit Metallen kombiniert:

Vorzugsweise betragen die Oberflächenverunreinigungen mit Metallen größer oder gleich 1,5 ppbw und kleiner oder gleich 100 ppbw. Vorzugsweise betragen die Oberflächenverunreinigungen mit Metallen größer oder gleich 0,2 ppbw und kleiner oder gleich 1,5 ppbw. Vorzugsweise betragen die Oberflächenverunreinigungen mit Metallen größer oder gleich 0,1 ppbw und kleiner oder gleich 0,2 ppbw.

Die Metalle der Oberflächenverunreinigungen des erfindungsgemäßen polykristallinen Silicium beinhalten vorzugsweise Fe, Cr, Ni, Na, Zn, Al, Cu, Mg, Ti, W, K, Co und Ca. Andere Metalle, wie Mn und Ag, liegen in vernachlässigbar kleinen Konzentrationen vor.

Vorzugsweise beträgt die Oberflächenverunreinigung mit Eisen größer oder gleich 0,01 ppbw und kleiner oder gleich 10 ppbw. Vorzugsweise beträgt die Oberflächenverunreinigung mit Eisen größer oder gleich 0,5 ppbw und kleiner oder gleich 10 ppbw. Vorzugsweise beträgt die Oberflächenverunreinigung mit Eisen größer oder gleich 0,05 ppbw und kleiner oder gleich 0,5 ppbw. Vorzugsweise beträgt die Oberflächenverunreinigung mit Eisen größer oder gleich 0,01 ppbw und kleiner oder gleich 0,05 ppbw.

Vorzugsweise beträgt die Oberflächenverunreinigung mit Wolfram größer oder gleich 0,01 ppbw und kleiner oder gleich 50 ppbw. Vorzugsweise beträgt die Oberflächenverunreinigung mit Wolfram größer oder gleich 0,5 ppbw und kleiner oder gleich 50 ppbw. Vorzugsweise beträgt die Oberflächenverunreinigung mit Wolfram größer oder gleich 0,05 ppbw und kleiner oder gleich 0,5 ppbw. Vorzugsweise beträgt die Oberflächenverunreinigung mit Wolfram größer oder gleich 0,01 ppbw und kleiner oder gleich 0,05 ppbw.

Weiterhin wird die Aufgabe der Erfindung gelöst durch polykristallines Silicium einer vierten Bruchgröße, enthaltend polykristalline Siliciumbruchstücke, wobei mindestens 90% der Bruchstücke eine Größe von 3 bis 15 mm aufweisen, gekennzeichnet durch Anteile an Siliciumstaubpartikeln von kleiner als 45 ppmw für Partikelgrößen von kleiner als 400 µm, von kleiner als 30 ppmw für Partikelgrößen von kleiner als 50 µm, von kleiner als 20 ppmw für Partikelgrößen von kleiner als 10 µm und von kleiner als 10 ppmw für Partikelgrößen von kleiner als 1 µm, und weiterhin gekennzeichnet durch Oberflächenverunreinigungen mit Metallen von größer oder gleich 0,1 ppbw und kleiner oder gleich 1 ppmw.

Vorzugweise beträgt der Anteil an Siliciumstaubpartikeln im polykristallinen Silicium dieser vierten Bruchgröße für Partikelgrößen von kleiner als 400 µm weniger als 30 ppmw. Ganz besonders bevorzugt beträgt der Anteil an Siliciumstaubpartikeln für Partikelgrößen von kleiner als 400 µm weniger als 15 ppmw.

Vorzugweise beträgt der Anteil an Siliciumstaubpartikeln für Partikelgrößen von kleiner als 50 µm weniger als 20 ppmw. Ganz besonders bevorzugt beträgt der Anteil an Siliciumstaubpartikeln für Partikelgrößen von kleiner als 50 µm weniger als 10 ppmw.

Vorzugweise beträgt der Anteil an Siliciumstaubpartikeln für Partikelgrößen von kleiner als 10 µm weniger als 15 ppmw. Ganz besonders bevorzugt beträgt der Anteil an Siliciumstaubpartikeln für Partikelgrößen von kleiner als 10 µm weniger als 6 ppmw.

Vorzugweise beträgt der Anteil an Siliciumstaubpartikeln für Partikelgrößen von kleiner als 1 µm weniger als 5 ppmw. Ganz besonders bevorzugt beträgt der Anteil an Siliciumstaubpartikeln für Partikelgrößen von kleiner als 1 µm weniger als 0,5 ppmw.

Die genannten bevorzugten und ganz besonders bevorzugten Anteile an Siliciumstaubpartikeln des erfindungsgemäßen polykristallinen Siliciums einer vierten Bruchgröße werden vorzugsweise mit folgenden bevorzugten Oberflächenverunreinigungen mit Metallen kombiniert:

Vorzugsweise betragen die Oberflächenverunreinigungen mit Metallen größer oder gleich 10 ppbw und kleiner oder gleich 1 ppmw. Vorzugsweise betragen die Oberflächenverunreinigungen mit Metallen größer oder gleich 4,5 ppbw und kleiner oder gleich 10 ppbw. Vorzugsweise betragen die Oberflächenverunreinigungen mit Metallen größer oder gleich 0,1 ppbw und kleiner oder gleich 4,5 ppbw.

Die Metalle der Oberflächenverunreinigungen des erfindungsgemäßen polykristallinen Silicium beinhalten vorzugsweise Fe, Cr, Ni, Na, Zn, Al, Cu, Mg, Ti, W, K, Co und Ca. Andere Metalle, wie Mn und Ag, liegen in vernachlässigbar kleinen Konzentrationen vor.

Vorzugsweise beträgt die Oberflächenverunreinigung mit Eisen größer oder gleich 0,01 ppbw und kleiner oder gleich 500 ppbw. Vorzugsweise beträgt die Oberflächenverunreinigung mit Eisen größer oder gleich 1,0 ppbw und kleiner oder gleich 500 ppbw. Vorzugsweise beträgt die Oberflächenverunreinigung mit Eisen größer oder gleich 0,3 ppbw und kleiner oder gleich 1,0 ppbw. Vorzugsweise beträgt die Oberflächenverunreinigung mit Eisen größer oder gleich 0,01 ppbw und kleiner oder gleich 0,3 ppbw.

Vorzugsweise beträgt die Oberflächenverunreinigung mit Wolfram größer oder gleich 0,01 ppbw und kleiner oder gleich 500 ppbw. Vorzugsweise beträgt die Oberflächenverunreinigung mit Wolfram größer oder gleich 10 ppbw und kleiner oder gleich 500 ppbw. Vorzugsweise beträgt die Oberflächenverunreinigung mit Wolfram größer oder gleich 1 ppbw und kleiner oder gleich 10 ppbw. Vorzugsweise beträgt die Oberflächenverunreinigung mit Wolfram größer oder gleich 0,01 ppbw und kleiner oder gleich 1 ppbw.

Weiterhin wird die Aufgabe der Erfindung gelöst durch polykristallines Silicium einer fünften Bruchgröße, enthaltend polykristalline Siliciumbruchstücke, wobei mindestens 90% der Bruchstücke eine Größe von 0,5 bis 5 mm aufweisen, gekennzeichnet durch Anteile an Siliciumstaubpartikeln von kleiner als 70 ppmw für Partikelgrößen von kleiner als 400 µm, von kleiner als 62 ppmw für Partikelgrößen von kleiner als 50 µm, von kleiner als 60 ppmw für Partikelgrößen von kleiner als 10 µm und von kleiner als 40 ppmw für Partikelgrößen von kleiner als 1 µm, und weiterhin gekennzeichnet durch Oberflächenverunreinigungen mit Metallen von größer oder gleich 0,1 ppbw und kleiner oder gleich 10 ppmw.

Vorzugweise beträgt der Anteil an Siliciumstaubpartikeln im polykristallinen Silicium dieser fünften Bruchgröße für Partikelgrößen von kleiner als 400 µm weniger als 40 ppmw. Ganz besonders bevorzugt beträgt der Anteil an Siliciumstaubpartikeln für Partikelgrößen von kleiner als 400 µm weniger als 20 ppmw.

Vorzugweise beträgt der Anteil an Siliciumstaubpartikeln für Partikelgrößen von kleiner als 50 µm weniger als 30 ppmw. Ganz besonders bevorzugt beträgt der Anteil an Siliciumstaubpartikeln für Partikelgrößen von kleiner als 50 µm weniger als 15 ppmw.

Vorzugweise beträgt der Anteil an Siliciumstaubpartikeln für Partikelgrößen von kleiner als 10 µm weniger als 25 ppmw. Ganz besonders bevorzugt beträgt der Anteil an Siliciumstaubpartikeln für Partikelgrößen von kleiner als 10 µm weniger als 12 ppmw.

Vorzugweise beträgt der Anteil an Siliciumstaubpartikeln für Partikelgrößen von kleiner als 1 µm weniger als 10 ppmw. Ganz besonders bevorzugt beträgt der Anteil an Siliciumstaubpartikeln für Partikelgrößen von kleiner als 1 µm weniger als 1 ppmw.

Die genannten bevorzugten und ganz besonders bevorzugten Anteile an Siliciumstaubpartikeln des erfindungsgemäßen polykristallinen Siliciums einer fünften Bruchgröße werden vorzugsweise mit folgenden bevorzugten Oberflächenverunreinigungen mit Metallen kombiniert:

Vorzugsweise betragen die Oberflächenverunreinigungen mit Metallen größer oder gleich 100 ppbw und kleiner oder gleich 10 ppmw. Vorzugsweise betragen die Oberflächenverunreinigungen mit Metallen größer oder gleich 20 ppbw und kleiner oder gleich 100 ppbw. Vorzugsweise betragen die Oberflächenverunreinigungen mit Metallen größer oder gleich 0,1 ppbw und kleiner oder gleich 20 ppbw.

Die Metalle der Oberflächenverunreinigungen des erfindungsgemäßen polykristallinen Silicium beinhalten vorzugsweise Fe, Cr, Ni, Na, Zn, Al, Cu, Mg, Ti, W, K, Co und Ca. Andere Metalle, wie Mn und Ag, liegen in vernachlässigbar kleinen Konzentrationen vor.

Vorzugsweise beträgt die Oberflächenverunreinigung mit Eisen größer oder gleich 0,01 ppbw und kleiner oder gleich 1 ppmw. Vorzugsweise beträgt die Oberflächenverunreinigung mit Eisen größer oder gleich 5,0 ppbw und kleiner oder gleich 1000 ppbw. Vorzugsweise beträgt die Oberflächenverunreinigung mit Eisen größer oder gleich 1,0 ppbw und kleiner oder gleich 5,0 ppbw. Vorzugsweise beträgt die Oberflächenverunreinigung mit Eisen größer oder gleich 0,01 ppbw und kleiner oder gleich 1,0 ppbw.

Vorzugsweise beträgt die Oberflächenverunreinigung mit Wolfram größer oder gleich 0,01 ppbw und kleiner oder gleich 5 ppmw. Vorzugsweise beträgt die Oberflächenverunreinigung mit Wolfram größer oder gleich 100 ppbw und kleiner oder gleich 5 ppmw. Vorzugsweise beträgt die Oberflächenverunreinigung mit Wolfram größer oder gleich 10 ppbw und kleiner oder gleich 100 ppbw. Vorzugsweise beträgt die Oberflächenverunreinigung mit Wolfram größer oder gleich 0,01 ppbw und kleiner oder gleich 10 ppbw.

Das polykristalline Silicium aller zuvor genannten Bruchgrößen erhält diese Eigenschaften bzgl. Oberflächenstaub und Metallkontaminationen ohne jegliche nasschemische Behandlung. Dies heißt nicht, dass eine nasschemische Behandlung in nachfolgenden Prozessschritten nicht vorteilhaft sein könnte, um z.B. noch niedrigere Metallkontaminationen zu erreichen oder um das polykristalline Silicium einer Ätzbehandlung der Oberfläche zu unterziehen.

Die niedrige Belastung mit Staubpartikeln resultiert aus einem besonderen Entstaubungsverfahren, das im Folgenden näher erläutert wird. Die Metallwerte sind in allen beanspruchten und bevorzugten Bereichen durch Anwendung kontaminationsarmer Bearbeitung, insbesondere beim Brechen des Siliciums in Bruchstücke sowie durch Wahl einer geeigneten Reinraumklasse zu erreichen.

Für besonders anspruchsvolle Anwendungen wird daher eine besonders kontaminationsarme Bearbeitung mit einer niedrigen Reinraumklasse kombiniert (nach US FED STD 209E, abgelöst durch ISO 14644-1), z.B. mit Reinraumklasse 100. Bei Klasse 100 (ISO 5) dürfen max. 3,5 Partikel von max. 0,5 µm Durchmesser pro Liter enthalten sein.

Die bei den verschiedenen Bruchgrößen genannten bevorzugten Bereiche für Oberflächenverunreinigungen mit Metallen sowie die Bereiche für Kontamination mit Eisen und Wolfram entsprechen niedrigeren und höheren Bereichen der beanspruchten Bereiche.

Bei den niedrigen Bereichen ist kontaminationsarme Bearbeitung notwendig. Dieses polykristalline Silicium ist für besonders anspruchsvolle Anwendungen geeignet, bei denen eine niedrige Kontamination mit Metallen gewünscht ist.

Vorzugsweise werden für alle genannten Bruchgrößen jeweils die höheren und die niedrigen Bereiche für Metall-, Eisen- und Wolfram-Kontamination miteinander kombiniert.

So sind beispielsweise für polykristallines Silicium einer dritten Bruchgröße folgende Metalikontaminationen besonders bevorzugt:
Für anspruchsvolle Anwendungen:

| | |
|---|---|
| Gesamtmetalle | 0,1 ppbw bis 0,2 ppbw, |
| Eisen | 0,01 ppbw bis 0,05 ppbw, |
| Wolfram | 0,01 ppbw bis 0,05 ppbw. |

Für weniger anspruchsvolle Anwendungen:

| | |
|---|---|
| Gesamtmetalle | 0, 2 ppbw bis 1,5 ppbw, |
| Eisen | 0, 05 ppbw bis 0,5 ppbw, |
| Wolfram | 0, 05 ppbw bis 0,5 ppbw. |

Die Erfindung wird auch gelöst durch ein Verfahren zur Herstellung von polykristallinem Silicium nach einem der Ansprüche 1 bis 6, umfassend Brechen von an Dünnstäben in einem Siemenseaktor abgeschiedenem polykristallinem Silicium in Bruchstücke, Klassieren der Bruchstücke in Größenklassen von etwa 0,5 mm bis größer als 45 mm und eine nachfolgende Behandlung der Bruchstücke mittels Druckluft oder Trockeneis bei einem Gasdruck von 1 bis 20 bar und einer Gasgeschwindigkeit von mindestens 2 m/s, um Siliciumstaub von den Bruchstücken zu entfernen, wobei keine chemische Nassreinigung erfolgt.

vorzugsweise wird dabei das Silicium mit kontaminationsarmem Werkzeug in Bruchstücke gebrochen.

Im Stand der Technik war es bislang üblich, die polykristallinnen Siliciumbruchstücke chemisch zu reinigen, um ein akzeptables Metall- und partikelniveau zu erreichen, wenn sie für Anwendungen in der Halbleitertechnologie vorgesehen sind.

Die Erfinder haben gezeigt, dass auch ungereinigtes Polysilicium, das eigentlich ein zu hohes Metallpartikel-Niveau aufweist, dennoch auch für anspruchsvolle Verwendungen in der Halbleitertechnologie geeignet ist, wenn es zuvor entstaubt wird.

Dies ist insofern überraschend, da metallische Verunreinigungen und sonstige Fremdpartikel im Polysiliciumbruch als eine der Hauptursachen für Versetzungen beim Ziehen von Einkristallen angesehen wurden. Polysilicium ohne nasschemische Behandlung weist eine x-fach höhere Metallverunreinigung auf als nasschemisch behandeltes Polysilicium. Diese liegt, wie zuvor offenbart, je nach Bruchgröße zwischen 0,1 ppbw und 10000 ppbw. Die herrschende Meinung ging davon aus, dass die Metallverunreinigungen bei maximal 100 pptw liegen dürften, um nicht beim Kristallziehen zu Problemen zu führen. Nun hat sich aber gezeigt, dass Siliciumstaub offenbar eine noch wichtigere Rolle spielt. Entstaubtes, nicht gereinigtes Polysilicium zeigt hervorragende Eigenschaften bei Ziehprozessen, trotz der vergleichsweise hohen Metallbelastung.

Außerdem wurde festgestellt, dass chemisch gereinigtes Polysilicium mit einem geringen Metallniveau von weniger als 100 pptw, das einer Entstaubung mittels Druckluft oder Trockeneis unterzogen wurde, ein reduziertes Silicium-PartikelNiveau unterhalb der Nachweisgrenze von ca. 1 ppmw aufweist, eine deutlich bessere Ziehperformance bei hochwertigen Anwendungen (z.B. Einkristallziehen für Halbleiteranwendung und anspruchsvolle Solaranwendungen) zeigt.

Die Einflüsse des auf dem Silicium anhaftenden Staubes, insbesondere in Form von Siliciumpartikeln der Größen von wenigen µm bis mehreren 100µm, wurden im Stand der Technik nicht ausreichend beachtet.

Die Erfinder haben festgestellt, dass auch beim Blockgießen von Silicium für Solaranwendungen das erfindungsgemäße polykristalline Silicium zu besseren Ergebnissen führt.

Dies gilt unabhängig von der Bruchgröße, die im Folgenden jeweils als längste Entfernung zweier Punkte auf der Oberfläche eines Silicium-Bruchstücks (=max. Länge) wie folgt definiert ist:
- Bruchgröße 0 (BG0) in mm: ca. 0.5 bis 5
- Bruchgröße 1 (BG1) in mm: ca. 3 bis 15
- Bruchgröße 2 (BG2) in mm: ca. 10 bis 40
- Bruchgröße 3 (BG3) in mm: ca. 20 bis 60
- Bruchgröße 4 (BG4) in mm: ca. > 45

Dabei liegen jeweils mindestens ca. 90 Gew.-% der Bruchfraktion innerhalb des genannten Größenbereiches.

Das Polysilicium wird vorzugsweise kontaminationsarm gebrochen.

Um besonders niedrige Metallwerte zu erreichen, werden alle Produkt berührenden Anlagenteile im Brecher und in den Siebanlagen vorzugsweise mit kontaminationsarmen Werkstoffen wie Kunststoffen oder Silicium oder anderen verschleißarmen Werkstoffen wie Keramiken, Quarz oder Hartmetallen ausgeführt.

Außerdem wird vorzugsweise in Reinraumklassen kleiner 1000, besonders bevorzugt kleiner 100 und ganz besonders bevorzugt kleiner 10 gearbeitet.

Die Entstaubung des kontaminationsarm gebrochen Polysiliciums erfolgt mittels Druckluft und/oder Trockeneis.

Dabei kann der Siliciumbruch während der Entstaubung statisch vorliegen oder aber auch umgelagert werden.

Die Entstaubung kann dabei bei allen technisch üblichen Drücken und verschiedenen Düsenanordnungen und Düsenmengen erfolgen. Die Entstaubung kann an einer oder mehreren Stellen in der Prozesskette erfolgen, d.h. beispielsweise direkt nach dem Brechen, und/oder nach dem Klassifizieren, und/oder kurz vor der Verpackung oder auch nach dem Transport, beispielsweise kurz vor dem Tiegeleinrichten.

Zum effektiven Abblasen der Silicium-Oberfläche können auch handelsübliche Druckluftpistolen verwendet werden. Bevorzugt werden diese Druckluftpistolen aus kontaminationsarmen Werkstoffen hergestellt, besonders bevorzugt aus Edelstahl, Hartmetallen oder Kunststoff (PU, PP oder PE).

Als Druckluft können Luft, Kohlendioxid, oder auch andere inerte Gase wie beispielsweise Stickstoff oder Argon verwendet werden. Denkbar sind auch beliebige Gasmischungen, oder auch Gaszusätze mit einer zusätzlichen chemischen Reinigungswirkung wie beispielsweise Ozon.

Bevorzugt wird bei der Herstellung von erfindungsgemäßem Polysilicium eine Entstaubung mit Gasdrücken von 1 bis 20 bar, bevorzugt 5 bis 10 bar angewendet. Bei kleinen Bruchgrößen wird dabei tendenziell mit kleineren Drücken gearbeitet.

Die Oberfläche der Silicium-Bruchstücke wird dabei mit einer Gasgeschwindigkeit von mindestens 2 m/s, bevorzugt größer 10 m/s und besonders bevorzugt größer 100 m/s abgeblasen.

Die Einwirkung des Gasstrahls auf die Silicium-Oberfläche kann ein oder auch mehrere kurze Impulse von weniger als einer Sekunde darstellen, als auch ein Dauerstrahl von mehreren Sekunden oder Minuten.

Damit es zu keiner Verunreinigung durch Fremdpartikel kommt, wird bevorzugt mit trockenen (Taupunkt <40°C), öl- und fettfreien, gereinigten Gasen und besonders bevorzugt mit Gasen in Halbleiterqualität, bzw. mit einem auf das Volumen bezogenem Fremdatomanteil von weniger als 10 ppm, bevorzugt kleiner 1 ppm und besonders bevorzugt kleiner 0,1 ppm gearbeitet.

Besonders gute Ergebnisse erreicht man, wenn möglichst nahe am Luftaustritt die Luft zusätzlich mit einem Partikelfilter kleiner 10 µm, bevorzugt kleiner 0,1 µm und besonders bevorzugt kleiner 0,001 µm gereinigt wird.

Je nach Bruchgröße der zu reinigenden Siliciumstücke und des Umfang der Staubbeladung der Oberfläche sind handelsübliche Hochdruckreiniger mit drehenden oder pulsierenden Düsen und mit unterschiedlichen Düsenformen möglich.

In einer weiteren bevorzugten Ausführungsform wird das zu reinigende Material auf einer Rüttelrinne oder über ein Transportband, bevorzugt mit einem staubdurchlässigen Siebgewebe, mit einer gegenüber der Bruchgröße etwas kleineren Maschenweite gefördert. Über diesen Fördereinheiten sind sowohl eine starke große Düse, als auch mehrer kleine Düsen in verschiedener Position, Ausführung und Orientierung zu den Si-Stücken möglich.

Besonders bevorzugt ist eine automatisierte Änderung der Orientierung des Siliciummaterials mittels einer oder mehrerer Wendeeinrichtungen.

Besonders bevorzugt erfolgt die Entstaubung des Siliciumbruchs mittels Trockeneis.

Die Trockeneisreinigung entfernt auf einer Oberfläche anhaftende Partikel, indem aufbereitetes CO₂ in Form von Trockeneispartikeln durch Hochgeschwindigkeitsdüsen geblasen wird. Fremdpartikel und Silicium-Staubpartikel werden durch eine Kombination von kinetischer Energie, Wärmeschockeinwirkung und einen Sublimationseffekt vom Silicium-Bruch abgelöst.

Überraschenderweise wurde gefunden, dass hierfür handelsübliche Reinigungsapparate (z.B. der Firma Cold Jet) verwendet werden können, wenn diese mit kontaminationsarmen Werkstoffen ausgestattet werden.

Bevorzugt wird dabei für den Trockeneisvorratsbehälter eine Kunststoffauskleidung (z.B. PU, PP oder PE) verwendet.

Wird die Anlage mit Trockeneisblöcken betrieben, so wird bevorzugt zur Herstellung der ca. minus 80°C kalten Eis-Partikel ein Bearbeitungswerkzeug aus verschleißarmer Keramik oder Hartmetall eingesetzt.

Damit es zu keiner Verunreinigung durch Fremdpartikel kommt, wird Reinst-Trockeneis, z.B. auf Basis von Kohlendioxidgas von Lebensmittelqualität verwendet.

Die Trockeneispartikel werden dabei mit Hilfe von gereinigten Gasen (gefilterte Druckluft, CO₂, inerte Gase wie Stickstoff in Halbleiterqualität oder Mischungen davon) bei einem Druck von 1 bis 20 bar, bevorzugt 3 bis 10 bar in einer "kontaminationsarmen" Venturidüse beschleunigt und aus dieser auf die zu reinigende Silicium-Oberfläche mit einer Geschwindigkeit von größer 2 m/s, bevorzugt größer 10 m/s, besonders bevorzugt größer 100 m/s geblasen.

Die Trockeneisreinigung hinterlässt so keinerlei Rückstände auf dem Polysilicium. Zudem bleibt das Material trocken. Eine aufwändige Trocknung wie bei nasschemischen Verfahren ist nicht erforderlich.

Der Eisverbrauch variiert dabei je nach Düsenausführung und Druckbereich.

Eine weitere bevorzugte Ausführungsform besteht in der Kombination von Entstaubung mittels Druckluft und Entstaubung mittels Trockeneis.

Durch Einsatz des erfindungsgemäßen Herstellungsverfahrens können in der Produktion erhebliche Kosten gesenkt werden, da beispielsweise auch Brech- und Sortieranlagen verwendet werden können, die sehr viel Staub erzeugen.

Das erfindungsgemäße Verfahren ist auch nicht begrenzt auf kompakte oder poröse Bruchstücke aus Polysilicium, sondern kann auch zur Entstaubung von anderen Produkten aus Polysilicium, wie beispielsweise Granulat oder sogenannten Cut-Rods oder FZ/CZ-Stäben verwendet werden.

Die Erfindung soll nun anhand von Beispielen und Vergleichsbeispielen näher erläutert werden.

### Beispiele

Mehrere polykristalline Siliciumstäbe wurden mit einem Brecher in Bruchstücke unterschiedlicher Größe gebrochen und klassiert. Das Feinmaterial wurde dabei mittels Sieben abgetrennt.

Um besonders niedrige Metallwerte zu erreichen, wurden alle Produkt berührenden Anlagenteile im Brecher und in den Klassieranlagen mit kontaminationsarmen Werkstoffen wie Kunststoffen oder Silicium oder anderen verschleißarmen Werkstoffen wie Keramiken, Quarz oder Hartmetallen ausgeführt.

Das Material wurde dabei auf Zielgröße Bruchgröße 4 gebrochen, wobei aber auch Bruchstücke aller anderen Größen entstehen. Anschließend wurden aus den verschiedenen klassierten Bruchgrößenfraktionen zufällig mehrere Proben entnommen und an diesen anhaftender Staub und Metalle gemessen.

Zur Bestimmung anhaftender Silicium-Partikel wurden mehrere Bruchstücke, mit einem Gewicht von mehreren 100g entnommen, in einen sauberen Siebstrumpf (Maschenweite 160µm) gegeben und die Partikel in einem Wasserbad abgelöst. Die Anzahl und Größe der Partikel im Wasserbad wurde dann bezogen auf die Silicium-Proben-Einwaage mit Laserbeugung, bzw. einem Beckmann Coulter LS 13320 bestimmt.

Zur Bestimmung der Oberflächenmetalle wurden ebenfalls zufällig mehrere Probestücke entnommen und die Metallkontamination mittels chemischen Ablösen der Silicium-Oberfläche und anschließender Analyse der abgelösten Lösung mit ICPMS bestimmt.

Die Ergebnisse sind in den **Tabellen 1 bis 4** dargestellt.

Es zeigen sich hohe Staubwerte, insbesondere bei kleinen Bruchgrößen.

Die Metallwerte liegen dagegen auf mittlerem Niveau, was aus der kontaminationsarmen Bearbeitung resultiert.

**Tabelle 1** zeigt die Staubwerte für die Bruchgröße 4.

Es sind jeweils für verschiedene maximale betrachtete Partikelgrößen die Konzentrationen in ppmw dargestellt.

**Tabelle 1 - Bruchgröße 4 - Staub [ppmw]**

| Partikel-Größe < 1 µm | Partikel-Größe < 5 µm | Partikel-Größe < 10 µm | Partikel-Größe < 20 µm | Partikel-Größe < 50 µm | Partikel-Größe < 400 µm |
|---|---|---|---|---|---|
| 1 | 2 | 2 | 2 | 2 | 2 |
| 2 | 6 | 9 | 11 | 14 | 14 |
| 1 | 4 | 5 | 7 | 10 | 11 |
| 1 | 3 | 5 | 8 | 11 | 12 |
| 1 | 4 | 5 | 8 | 11 | 13 |
| 2 | 4 | 6 | 9 | 13 | 17 |
| 2 | 4 | 6 | 8 | 13 | 18 |
| 1 | 3 | 5 | 6 | 9 | 13 |
| 2 | 4 | 6 | 8 | 12 | 17 |
| 2 | 5 | 7 | 9 | 15 | 19 |
| 1 | 4 | 5 | 7 | 11 | 14 |
| 1 | 3 | 5 | 7 | 10 | 14 |
| 1 | 4 | 5 | 7 | 10 | 14 |
| 1 | 3 | 4 | 6 | 7 | 9 |
| 1 | 3 | 4 | 6 | 9 | 13 |
| 2 | 4 | 6 | 9 | 18 | 28 |

**Tabelle 2** zeigt die Staubwerte für Bruchgröße 3 in ppmw.

Es sind jeweils für verschiedene maximale betrachtete Partikelgrößen die Konzentrationen in ppmw dargestellt.

**Tabelle 2 - Bruchgröße 3 - Staub [ppmw]**

| Partikel-Größe< 1 µm | Partikel-Größe < 5 µm | Partikel-Größe < 10 µm | Partikel-Größe < 20 µm | Partikel-Größe < 50 µm | Partikel-Größe < 400 µm |
|---|---|---|---|---|---|
| 2 | 3 | 3 | 3 | 3 | 3 |
| 2 | 3 | 3 | 3 | 3 | 3 |
| 3 | 6 | 8 | 9 | 11 | 11 |
| 2 | 6 | 7 | 10 | 13 | 13 |
| 2 | 5 | 7 | 9 | 12 | 14 |
| 4 | 8 | 10 | 12 | 14 | 14 |
| 3 | 8 | 10 | 14 | 19 | 24 |
| 2 | 5 | 6 | 8 | 12 | 16 |
| 2 | 5 | 7 | 8 | 11 | 16 |
| 2 | 6 | 8 | 10 | 14 | 18 |
| 2 | 4 | 6 | 8 | 13 | 20 |
| 3 | 6 | 8 | 10 | 13 | 18 |
| 3 | 6 | 8 | 10 | 14 | 20 |
| 3 | 5 | 7 | 8 | 11 | 15 |
| 3 | 5 | 7 | 9 | 12 | 20 |
| 3 | 5 | 7 | 8 | 10 | 13 |

**Tabelle 3** zeigt die Staubwerte für Bruchgröße 2 in ppmw.

Es sind jeweils für verschiedene maximale betrachtete Partikelgrößen die Konzentrationen in ppmw dargestellt.

**Tabelle 3 - Bruchgröße 2 - Staub [ppmw]**

| Partikel-Größe < 1 µm | Partikel-Größe < 5 µm | Partikel-Größe < 10 µm | Partikel-Größe < 20 µm | Partikel-Größe < 50 µm | Partikel-Größe < 400 µm |
|---|---|---|---|---|---|
| 1 | 3 | 4 | 5 | 5 | 5 |
| 2 | 4 | 6 | 7 | 8 | 8 |
| 2 | 4 | 6 | 7 | 9 | 9 |
| 2 | 5 | 6 | 8 | 9 | 9 |
| 2 | 4 | 6 | 7 | 9 | 10 |
| 2 | 5 | 6 | 8 | 10 | 10 |
| 3 | 4 | 4 | 4 | 4 | 4 |
| 3 | 5 | 5 | 5 | 5 | 5 |
| 4 | 8 | 10 | 11 | 13 | 13 |
| 4 | 9 | 12 | 15 | 18 | 18 |
| 3 | 6 | 7 | 9 | 12 | 13 |
| 4 | 8 | 10 | 13 | 16 | 17 |
| 4 | 8 | 10 | 13 | 18 | 21 |
| 3 | 6 | 7 | 9 | 12 | 13 |
| 3 | 6 | 8 | 10 | 13 | 19 |
| 3 | 6 | 8 | 11 | 18 | 27 |
| 3 | 6 | 8 | 10 | 14 | 18 |
| 2 | 4 | 6 | 8 | 11 | 16 |
| 3 | 6 | 7 | 9 | 11 | 16 |
| 4 | 7 | 8 | 9 | 11 | 15 |
| 3 | 6 | 8 | 10 | 14 | 21 |
| 3 | 7 | 8 | 10 | 14 | 21 |
| 3 | 6 | 8 | 10 | 15 | 21 |
| 4 | 7 | 8 | 10 | 13 | 19 |
| 3 | 6 | 8 | 10 | 13 | 18 |

**Tabelle 4** zeigt die Staubwerte für Bruchgröße 1 in ppmw

Es sind jeweils für verschiedene maximale betrachtete Partikelgrößen die Konzentrationen in ppmw dargestellt.

**Tabelle 4 - Bruchgröße 1 - Staub [ppmw]**

| Partikel-Größe < 1 µm | Partikel-Größe < 5 µm | Partikel-Größe < 10 µm | Partikel-Größe < 20 µm | Partikel-Größe <50 µm | Partikel-Größe < 400 µm |
|---|---|---|---|---|---|
| 9 | 15 | 17 | 17 | 17 | 17 |
| 8 | 14 | 16 | 16 | 16 | 16 |
| 7 | 12 | 14 | 17 | 25 | 30 |
| 6 | 11 | 13 | 16 | 25 | 40 |
| 7 | 14 | 17 | 21 | 31 | 47 |
| 8 | 13 | 15 | 18 | 27 | 43 |
| 10 | 15 | 17 | 20 | 26 | 36 |
| 7 | 12 | 15 | 20 | 31 | 56 |
| 9 | 15 | 18 | 23 | 37 | 55 |
| 9 | 15 | 18 | 22 | 29 | 42 |
| 12 | 20 | 23 | 27 | 36 | 50 |
| 7 | 15 | 19 | 25 | 40 | 59 |
| 9 | 20 | 26 | 33 | 53 | 75 |
| 9 | 15 | 18 | 21 | 31 | 47 |

**Tabelle 5** zeigt die Staubwerte für Bruchgröße 0 in ppmw.

Es sind jeweils für verschiedene maximale betrachtete Partikelgrößen die Konzentrationen in ppmw dargestellt.

**Tabelle 5 - Bruchgröße 0 - Staub [ppmw]**

| Partikel-Größe < 1 µm | Partikel-Größe < 5 µm | Partikel-Größe < 10 µm | Partikel-Größe < 20 µm | Partikel-Größe < 50 µm | Partikel-Größe < 400 µm |
|---|---|---|---|---|---|
| 35 | 55 | 59 | 59 | 59 | 59 |
| 36 | 56 | 61 | 61 | 61 | 61 |
| 37 | 58 | 62 | 67 | 75 | 114 |
| 30 | 46 | 49 | 50 | 50 | 50 |
| 34 | 51 | 54 | 57 | 58 | 58 |

**Tabelle 6** zeigt die Metallwerte nach Bruchgrößen in pptw.

**Tabelle 6**

| **BG4** | **Fe** | **Cr** | **Ni** | **Na** | **Zn** | **Al** | **Cu** | **Mg** | **Ti** | **W** | **K** | **Ca** | **Co** | **Gesamt** |
|---|---|---|---|---|---|---|---|---|---|---|---|---|---|---|
| #1 | 384 | 5 | 13 | 7 | 12 | 19 | 1 | 11 | 15 | 105 | 2 | 590 | 53 | 1218 |
| #2 | 53 | 11 | 5 | 3 | 1 | 1 | 1 | 1 | 2 | 60 | 5 | 11 | 52 | 205 |
| #3 | 76 | 16 | 7 | 3 | 1 | 12 | 1 | 6 | 7 | 175 | 5 | 18 | 26 | 352 |
| #4 | 11 | 7 | 3 | 4 | 1 | 7 | 1 | 1 | 1 | 216 | 5 | 26 | 27 | 311 |
| #5 | 127 | 29 | 12 | 4 | 1 | 71 | 1 | 7 | 4 | 397 | 6 | 15 | 51 | 726 |
| ***Mittelwert*** | ***130*** | ***14*** | ***8*** | ***4*** | ***3*** | ***22*** | ***1*** | ***5*** | ***6*** | ***191*** | ***5*** | ***132*** | ***42*** | ***562*** |
| | | | | | | | | | | | | | | |

| **BG3** | **Fe** | **Cr** | **Ni** | **Na** | **Zn** | **Al** | **Cu** | **Mg** | **Ti** | **W** | **K** | **Ca** | **Co** | **Gesamt** |
|---|---|---|---|---|---|---|---|---|---|---|---|---|---|---|
| #1 | 79 | 12 | 6 | 34 | 15 | 16 | 4 | 5 | 1 | 201 | 7 | 99 | 25 | 506 |
| #2 | 130 | 27 | 14 | 14 | 6 | 60 | 2 | 9 | 3 | 342 | 7 | 519 | 79 | 1212 |
| #3 | 248 | 14 | 7 | 16 | 8 | 18 | 1 | 36 | 5 | 185 | 7 | 220 | 38 | 803 |
| #4 | 109 | 17 | 8 | 5 | 4 | 16 | 17 | 3 | 4 | 216 | 3 | 62 | 31 | 495 |
| #5 | 141 | 19 | 8 | 11 | 7 | 12 | 10 | 3 | 3 | 388 | 4 | 29 | 42 | 678 |
| ***Mittelwert*** | ***142*** | ***18*** | ***8*** | ***16*** | ***8*** | ***24*** | ***7*** | ***12*** | ***3*** | ***267*** | ***6*** | ***186*** | ***43*** | ***739*** |
| | | | | | | | | | | | | | | |

| **BG2** | **Fe** | **Cr** | **Ni** | **Na** | **Zn** | **Al** | **Cu** | **Mg** | **Ti** | **W** | **K** | **Ca** | **Co** | **Gesamt** |
|---|---|---|---|---|---|---|---|---|---|---|---|---|---|---|
| #1 | 144 | 16 | 7 | 33 | 7 | 18 | 2 | 2 | 2 | 297 | 11 | 36 | 70 | 645 |
| #2 | 94 | 17 | 7 | 10 | 4 | 21 | 3 | 2 | 3 | 308 | 14 | 59 | 82 | 622 |
| #3 | 91 | 19 | 8 | 8 | 15 | 2 | 1 | 24 | 1 | 478 | 9 | 1013 | 71 | 1740 |
| #4 | 126 | 21 | 12 | 65 | 8 | 18 | 2 | 33 | 3 | 374 | 23 | 1373 | 76 | 2134 |
| #5 | 181 | 15 | 7 | 40 | 14 | 25 | 3 | 20 | 6 | 157 | 19 | 246 | 40 | 771 |
| ***Mittelwert*** | ***127*** | ***17*** | ***8*** | ***31*** | ***10*** | ***17*** | ***2*** | ***16*** | ***3*** | ***323*** | ***15*** | ***545*** | ***68*** | ***1183*** |
| | | | | | | | | | | | | | | |

| **BG1** | **Fe** | **Cr** | **Ni** | **Na** | **Zn** | **Al** | **Cu** | **Mg** | **Ti** | **W** | **K** | **Ca** | **Co** | **Gesamt** |
|---|---|---|---|---|---|---|---|---|---|---|---|---|---|---|
| #1 | 413 | 85 | 38 | 86 | 23 | 11 | 5 | 8 | 27 | 7500 | 713 | 101 | 1037 | 10048 |
| #2 | 368 | 72 | 35 | 22 | 10 | 12 | 5 | 14 | 28 | 6353 | 7 | 137 | 585 | 7647 |
| #3 | 485 | 88 | 40 | 85 | 16 | 21 | 6 | 32 | 32 | 2100 | 797 | 408 | 584 | 4693 |
| #4 | 1002 | 162 | 71 | 82 | 58 | 150 | 13 | 74 | 36 | 5596 | 200 | 855 | 568 | 8865 |
| #5 | 353 | 56 | 26 | 56 | 42 | 71 | 3 | 15 | 19 | 4064 | 90 | 541 | 462 | 5798 |
| ***Mittelwert*** | ***524*** | ***93*** | ***42*** | ***66*** | ***30*** | ***53*** | ***6*** | ***29*** | ***29*** | ***5122*** | ***362*** | ***408*** | ***647*** | ***7410*** |
| | | | | | | | | | | | | | | |

| **BG0** | **Fe** | **Cr** | **Ni** | **Na** | **Zn** | **Al** | **Cu** | **Mg** | **Ti** | **W** | **K** | **Ca** | **Co** | **Gesamt** |
|---|---|---|---|---|---|---|---|---|---|---|---|---|---|---|
| #1 | 1328 | 128 | 40 | 1760 | 2264 | 5 | 48 | 48 | 744 | 18824 | 1160 | 1000 | 2352 | 29701 |
| #2 | 1392 | 46 | 20 | 1538 | 5 | 5 | 46 | 20 | 792 | 23754 | 1077 | 1000 | 3685 | 33381 |
| #3 | 1065 | 8 | 20 | 211 | 68 | 5 | 8 | 20 | 1208 | 64631 | 169 | 1000 | 9330 | 77744 |
| #4 | 1995 | 195 | 75 | 2000 | 1748 | 1500 | 45 | 20 | 998 | 32948 | 675 | 1000 | 4868 | 48065 |
| #5 | 994 | 51 | 20 | 171 | 5 | 5 | 9 | 20 | 1183 | 31911 | 86 | 1000 | 4234 | 39690 |
| ***Mittelwert*** | ***1355*** | ***86*** | ***35*** | ***1136*** | ***818*** | ***304*** | ***31*** | ***26*** | ***985*** | ***34414*** | ***633*** | ***1000*** | ***4894*** | ***45716*** |

### Beispiel 1

Nun wurde das erfindungsgemäße Verfahren auf die Silicium-Bruchstücke angewendet.

Es wurden je mehrere 100 g-Bruchstücke mit Bruchgrößenverteilungen 0 bis 4 entnommen und erfindungsgemäß mit getrockneter, ölfreier und mittels eines 0,1 µm Partikelfilter gereinigter Druckluft mit einer handelsüblichen Handdüse bei mechanischer Umlagerung auf einem Kunststoffsieb mit einer zur Bruchgröße etwas kleineren Maschenweite (Größe der Maschenweite: bevorzugt ca. 50% der unteren Längengrenze der jeweiligen Bruchgröße), für 1 bis 10 Sekunden abgeblasen. Der Druck lag bei ca. 5 bar, mit einer Luftaustrittsgeschwindigkeit an der Düse (Querschnittsöffnung ca. 1mm²) von über 10 m/s.

Anschließend wurden an zufällig ausgewählten Probestücken die Staubbelastung und die Konzentration von Wolfram gemessen.

Bei allen Bruchgrößen konnten die Parktikelgrößen des anhaftenden Staubes im Mittel um einen Faktor größer 2 reduziert werden.

Die Ergebnisse zeigen anhand des Monitorelements W, dass auch eine leichte Reduzierung der Kontamination mit Oberflächenmetallen erreicht wird. Die Verunreinigung mit Metallen befindet sich grundsätzlich auf mittlerem Niveau gemäß **Tabelle 6.**

Die Entstaubung führt aber überraschenderweise auch zu einer leichten Reduktion des Metallniveaus, sichtbar anhand des Monitorelements Wolfram. Für Wolfram ergab sich 120 pptw.

**Tabelle 7** zeigt die Staubwerte für alle Bruchgrößen des **Beispiels 1** in ppmw.

Es ist eine deutliche Verbesserung zu erkennen. REM-Aufnahmen (nicht dargestellt) bestätigen, dass die Menge der pro Fläche sichtbaren anhaftenden Si-Partikel reduziert wurde.

**Tabelle 7**

| Bruchgröße | Partikelgröße < 1µm | Partikelgröße < 10µm | Partikelgröße < 50µm | Partikelgröße < 400µm |
|---|---|---|---|---|
| BG0 | 3,0 | 15 | 20 | 22 |
| BG0 | 5,0 | 20 | 22 | 28 |
| BG0 | 1,0 | 5 | 8 | 9 |
| BG0 | 13 | 8 | 10 | 11 |
| BG0 | 4,0 | 12 | 13 | 15 |
| BG1 | 1,0 | 10 | 17 | 26 |
| BG1 | 1,2 | 6 | 10 | 15 |
| BG1 | 0,5 | 4 | 6 | 9 |
| BG1 | 1,5 | 4 | 7 | 11 |
| BG1 | 2,0 | 5 | 8 | 12 |
| BG2 | 0,8 | 1,3 | 1,3 | 1,3 |
| BG2 | 1,0 | 1,3 | 1,3 | 1,3 |
| BG2 | 0,7 | 1,3 | 1,3 | 1,3 |
| BG2 | 1,4 | 0,8 | 0,8 | 0,8 |
| BG2 | 1,5 | 1,7 | 2 | 2 |
| BG2 | | 1,4 | 1,4 | 1,4 |
| BG2 | | 1,3 | 1,3 | 1,3 |
| BG2 | | 0,7 | 0,7 | 0,7 |
| BG2 | | 1,3 | 2 | 2 |
| BG2 | | 4 | 8 | 9 |
| BG2 | | 4 | 7 | 9 |
| BG2 | | 2 | 6 | 11 |
| BG2 | | 3 | 7 | 11 |
| BG2 | | 1,0 | 2 | 4 |
| BG2 | | 2 | 5 | 9 |
| BG3 | 0,7 | 3 | 4 | 4 |
| BG3 | 0,5 | 4 | 6 | 7 |
| BG3 | 0,8 | 0,8 | 3 | 5 |
| BG3 | 1,0 | 1,6 | 4 | 8 |
| BG3 | 1,1 | 2 | 6 | 10 |
| BG3 | | 0,2 | 0,5 | 0,9 |
| BG3 | | 2 | 6 | 9 |
| BG4 | 0,5 | 1,4 | 5 | 6 |
| BG4 | 0,3 | 1,1 | 3 | 4 |
| BG4 | 0,9 | 0,9 | 3 | 5 |
| BG4 | 0,6 | 1,7 | 5 | 10 |
| BG4 | 0,4 | 1,2 | 4 | 9 |
| BG4 | | 0,7 | 2 | 3 |

### Beispiel 2

Es wurde analog **Beispiel 1** vorgegangen und aus den wie vorher beschrieben kontaminationsarm hergestellten verschiedenen Si-Bruchgrößenverteilungen Bruchgröße 0 bis 4, je mehrere 100 g-Stücke entnommen und erfindungsgemäß mittels Trockeneis entstaubt.

Dafür wurde ein handelsübliches mobiles Gerät der Firma ColdJet verwendet (Typ Aero), mit einer Trockeneisdurchsatzrate von etwa 1 kg/min.

Das Trockeneis weist eine Verunreinigung von nur wenigen ppta an Metallen (Fe, Cr, Ca, etc...) auf.

Die Polysilicium-Bruchstücke wurden anschließend manuell auf einem PU-Kunststoffsieb, mit einer zur Bruchgröße etwas kleineren Maschenweite (Größe ca. 50% der unteren Längengrenze der jeweiligen Bruchgröße), per Hand umgelagert und für 1 bis 10 Sekunden mit einer Flachdüse abgeblasen.

Die Düse hatte eine Querschnittsöffnung von in der Länge mehreren cm und in der Breite von mehreren mm.

Der Druck lag je nach Bruchgröße zw. 1 und 10 bar, mit einer Luftaustrittsgeschwindigkeit an der Düse von über 10 m/s.

Bei kleineren Bruchgrößen wurde mit reduzierter Leistung, bzw. Druck des Gerätes entstaubt.

Anschließend wurden wieder an zufällig ausgewählten Probestücken die Staubbelastung und Metalle gemessen.

Die Metalle konnten, wieder gemessen am Monitorelement Wolfram, gegenüber der Reinigung mittels Druckluft nochmals leicht verbessert werden.

Weiterhin sind bei allen Bruchgrößen alle Partikelgrößen (im Vergleich zum Referenzbeispiel) um einen Faktor größer 3 reduziert.

**Tabelle 8** zeigt die Staubwerte in ppmw für alle Bruchgrößen aus **Beispiel 2.**

**Tabelle 8**

| Bruchgröße | Partikelgröße < 1µm | Partikelgröße < 10µm | Partikelgröße < 50µm | Partikelgröße < 400µm |
|---|---|---|---|---|
| BG0 | 6 | 8 | 17 | 22 |
| BG0 | 2 | 15 | 18 | 20 |
| BG0 | 3 | 2 | 5 | 5 |
| BG0 | 0,5 | 7 | 10 | 11 |
| BG0 | 2 | 12 | 12 | 13 |
| BG1 | 1,0 | 1,5 | 2 | 3 |
| BG1 | 1,4 | 3 | 5 | 7 |
| BG1 | 0 | 3 | 4 | 7 |
| BG1 | 2 | 3 | 7 | 17 |
| BG1 | 2 | 4 | 6 | 13 |
| BG1 | | 4 | 6 | 9 |
| BG1 | | 4 | 8 | 9 |
| BG2 | 0,8 | 1,5 | 2 | 4 |
| BG2 | 1,2 | 2 | 3 | 5 |
| BG2 | 0,7 | 1,2 | 2 | 4 |
| BG2 | 1,4 | 3 | 5 | 8 |
| BG2 | 1,3 | 2 | 4 | 7 |
| BG2 | | 2 | 2 | 4 |
| BG3 | 0,7 | 3 | 6 | 10 |
| BG3 | 0,3 | 0,9 | 3 | 4 |
| BG3 | 0,8 | 0,7 | 3 | 6 |
| BG3 | 0,3 | 2 | 7 | 12 |
| BG3 | 1,1 | | | |
| BG4 | 0,5 | 1,2 | 4 | 6 |
| BG4 | 0,3 | 0,5 | 1,3 | 2 |
| BG4 | 0,7 | 1,0 | 3 | 4 |
| BG4 | 0,6 | 1,7 | 6 | 9 |
| BG4 | 0,2 | 1,1 | 4 | 7 |

Die Verunreinigung mit Metallen befindet sich auf mittlerem Niveau.

**Tabelle 9** zeigt die Konzentrationen an Wolfram für **Beispiel 1** (Druckluft), **Beispiel 2** (Trockeneis) und als Referenz die Werte nach kontaminationsarmer Bearbeitung, jedoch ohne Entstaubung, vgl. **Tabelle 6**, jeweils in pptw.

Wolfram wird deshalb zum Vergleich separat dargestellt, da hier eine Querkontamination durch das Umfeld und Handling ausgeschlossen werden kann.

**Tabelle 9**

| **BG4** | **Referenz** | **Druckluft** | **Trockeneis** |
|---|---|---|---|
| Wolfram | 105 | 51 | 36 |
| [pptw] | 60 | 61 | 40 |
| | 175 | 116 | 56 |
| | 216 | 106 | 44 |
| | 397 | 266 | 254 |
| ***Mittel*** | ***191*** | ***120*** | ***86*** |

### Vergleichsbeispiel

Im Vergleichsbeispiel wurde kompakt abgeschiedenes, nicht poröses Poly-Si mittels eines Verfahrens analog DE 10 2006 035 081 A1 gebrochen, klassiert, chemisch gereinigt und in PE-Beutel verpackt zur Analytik transportiert. Im Vergleichsbeispiel erfolgt also eine nasschemische Reinigung.

Anschließend wurden aus verschiedenen PE-Beuteln zufällig Probestücke der Größe 4 entnommen, die Staubbelastung und Metalle gemessen und eine REM-Aufnahme gemacht.

Hier ergibt sich, dass sich alle Staubwerte, vgl. Tabelle 11, an der Nachweisgrenze befinden. Die Metallwerte, vgl. **Tabelle 10,** sind deutlich niedriger als in den **Beispielen 1** und **2, vgl. Tabelle 6**

**Tabelle 10** zeigt die Metallwerte für das **Vergleichsbeispiel** in pptw.

**Tabelle 10**

| BG4 | **Fe** | **Cr** | **Ni** | **Na** | **Zn** | **Al** | **Cu** | **Ti** | **W** | **K** | **Co** | **Mn** | **Ca** | **Mg** | **Summe** |
|---|---|---|---|---|---|---|---|---|---|---|---|---|---|---|---|
| #1 | 4 | 0 | 0 | 2 | 0 | 3 | 2 | 7 | 0 | 5 | 1 | 0 | 20 | 1 | 45 |
| #2 | 2 | 3 | 0 | 1 | 0 | 3 | 1 | 2 | 2 | 1 | 2 | 1 | 9 | 1 | 28 |
| #3 | 2 | 0 | 0 | 2 | 2 | 2 | 3 | 3 | 0 | 4 | 1 | 0 | 16 | 2 | 38 |
| #4 | 8 | 1 | 1 | 6 | 1 | 0 | 1 | 4 | 0 | 4 | 0 | 0 | 3 | 7 | 36 |
| #5 | 6 | 0 | 0 | 2 | 1 | 0 | 0 | 10 | 1 | 4 | 0 | 1 | 1 | 1 | 27 |
| #6 | 5 | 0 | 1 | 2 | 0 | 1 | 0 | 3 | 1 | 1 | 0 | 1 | 30 | 4 | 50 |
| ***Mittel*** | ***4*** | ***1*** | ***0*** | ***2*** | ***1*** | ***2*** | ***1*** | ***5*** | ***1*** | ***3*** | ***1*** | ***1*** | ***13*** | ***3*** | ***37*** |

**Tabelle 11** zeigt die Staubwerte für das **Vergleichsbeispiel** in ppmw.

**Tabelle 11**

| Bruchgröße | Partikel-Größe < 1µm | Partikel-Größe < 10µm | Partikel-Größe < 50µm | Partikel-Größe < 400µm |
|---|---|---|---|---|
| BG0 | 6 | 8 | 17 | 22 |
| BG0 | 2 | 15 | 18 | 20 |
| BG0 | 3 | 2 | 5 | 5 |
| BG0 | 0,5 | 7 | 10 | 11 |
| BG0 | 2 | 12 | 12 | 13 |
| BG1 | 1,0 | 1,5 | 2 | 3 |
| BG1 | 1,4 | 3 | 5 | 7 |
| BG1 | 0,3 | 3 | 4 | 7 |
| BG1 | 2 | 3 | 7 | 17 |
| BG1 | 2 | 4 | 6 | 13 |
| BG1 | | 4 | 6 | 9 |
| BG1 | | 4 | 8 | 9 |
| BG2 | 0,8 | 1,5 | 2 | 4 |
| BG2 | 1,2 | 2 | 3 | 5 |
| BG2 | 0 , 7 | 1,2 | 2 | 4 |
| BG2 | 1,4 | 3 | 5 | 8 |
| BG2 | 1,3 | 2 | 4 | 7 |
| BG2 | | 2 | 2 | 4 |
| BG3 | 0,7 | 3 | 6 | 10 |
| BG3 | 0,3 | 0,9 | 3 | 4 |
| BG3 | 0,8 | 0,7 | 3 | 6 |
| BG3 | 0,3 | 2 | 7 | 12 |
| BG3 | 1,1 | | | |
| BG4 | 0,5 | 1,2 | 4 | 6 |
| BG4 | 0,3 | 0,5 | 1,3 | 2 |
| BG4 | 0,7 | 1,0 | 3 | 4 |
| BG4 | 0, 6 | 2 | 6 | 9 |
| BG4 | 0,2 | 1,1 | 4 | 7 |

Es zeigt sich, dass durch nasschemische Reinigung deutlich bessere Metallwerte resultieren als nach dem erfindungsgemäßen Verfahren.

Allerdings war es das Ziel der Erfindung, besonders günstiges polykristallines Silicium bereit zu stellen, das auf eine aufwändige und teure nasschemische Behandlung verzichten kann.

Die Erfinder haben erkannt, dass Siliciumstaub für viele Anwendung kritischer ist als eine Belastung mit Metallen, solange sich die Metallkontamination auf einem akzeptablen, mittleren Niveau bewegt. Dies konnte durch kontaminationsarme Bearbeitung, bei besonders anspruchsvollen Anwendungen in Verbindung mit einer niedrigen Reinraumklasse, sowie durch das erfindungsgemäße Entstaubungsverfahren erreicht werden.

Somit steht mit der vorliegenden Erfindung deutlich günstigeres polykristallines Silicium mit sehr niedrigen Staubanteilen und mit für viele Anwendungen akzeptabler Metallkontamination zur Verfügung.

## Patentansprüche

1. Polykristallines Silicium, enthaltend polykristalline Siliciumbruchstücke, wobei mindestens 90% der Bruchstücke eine Größe von 10 bis 40 mm aufweisen, **gekennzeichnet durch** Anteile an Siliciumstaubpartikeln von kleiner als 15 ppmw für Partikelgrößen von kleiner als 400 µm, von kleiner als 14 ppmw für Partikelgrößen von kleiner als 50 µm, von kleiner als 10 ppmw für Partikelgrößen von kleiner als 10 µm und von kleiner als 3 ppmw für Partikelgrößen von kleiner als 1 µm, und weiterhin **gekennzeichnet durch** Oberflächenverunreinigungen mit Metallen von größer oder gleich 0,1 ppbw und kleiner oder gleich 100 ppbw.

2. Polykristallines Silicium, enthaltend polykristalline Siliciumbruchstücke, wobei mindestens 90% der Bruchstücke eine Größe von 20 bis 60 mm aufweisen, **gekennzeichnet durch** Anteile an Siliciumstaubpartikeln von kleiner als 15 ppmw für Partikelgrößen von kleiner als 400 µm, von kleiner als 14 ppmw für Partikelgrößen von kleiner als 50 µm, von kleiner als 10 ppmw für Partikelgrößen von kleiner als 10 µm und von kleiner als 3 ppmw für Partikelgrößen von kleiner als 1 µm, und weiterhin **gekennzeichnet durch** Oberflächenverunreinigungen mit Metallen von größer oder gleich 0,1 ppbw und kleiner oder gleich 100 ppbw.

3. Polykristallines Silicium, enthaltend polykristalline Siliciumbruchstücke, wobei mindestens 90% der Bruchstücke eine Größe von mehr als 45 mm aufweisen, **gekennzeichnet durch** Anteile an Siliciumstaubpartikeln von kleiner als 15 ppmw für Partikelgrößen von kleiner als 400 µm, von kleiner als 14 ppmw für Partikelgrößen von kleiner als 50 µm, von kleiner als 10 ppmw für Partikelgrößen von kleiner als 10 µm und von kleiner als 3 ppmw für Partikelgrößen von kleiner als 1 µm, und weiterhin **gekennzeichnet durch** Oberflächenverunreinigungen mit Metallen von größer oder gleich 0,1 ppbw und kleiner oder gleich 100 ppbw.

4. Polykristallines Silicium, enthaltend polykristalline Siliciumbruchstücke, wobei mindestens 90% der Bruchstücke eine Größe von 3 bis 15 mm aufweisen, **gekennzeichnet durch** Anteile an Siliciumstaubpartikeln von kleiner als 45 ppmw für Partikelgrößen von kleiner als 400 µm, von kleiner als 30 ppmw für Partikelgrößen von kleiner als 50 µm, von kleiner als 20 ppmw für Partikelgrößen von kleiner als 10 µm und von kleiner als 10 ppmw für Partikelgrößen von kleiner als 1 µm, und weiterhin **gekennzeichnet durch** Oberflächenverunreinigungen mit Metallen von größer oder gleich 0,1 ppbw und kleiner oder gleich 1 ppmw.

5. Polykristallines Silicium, enthaltend polykristalline Siliciumbruchstücke, wobei mindestens 90% der Bruchstücke eine Größe von 0,5 bis 5 mm aufweisen, **gekennzeichnet durch** Anteile an Siliciumstaubpartikeln von kleiner als 70 ppmw für Partikelgrößen von kleiner als 400 µm, von kleiner als 62 ppmw für Partikelgrößen von kleiner als 50 µm, von kleiner als 60 ppmw für Partikelgrößen von kleiner als 10 µm und von kleiner als 40 ppmw für Partikelgrößen von kleiner als 1 µm, und weiterhin **gekennzeichnet durch** Oberflächenverunreinigungen mit Metallen von größer oder gleich 0,1 ppbw und kleiner oder gleich 10 ppmw.

6. Polykristallines Silicium nach einem der Ansprüche 1 bis 5, wobei die Metalle der Oberflächenverunreinigungen Fe, Cr, Ni, Na, Zn, Al, Cu, Mg, Ti, W, K, Co und Ca beinhalten.

7. Verfahren zur Herstellung von polykristallinem Silicium nach einem der Ansprüche 1 bis 6, umfassend Brechen von an Dünnstäben in einem Siemensreaktor abgeschiedenem polykristallinem Silicium in Bruchstücke, Klassieren der Bruchstücke in Größenklassen von etwa 0,5 mm bis größer als 45 mm und Behandlung der Bruchstücke mittels Druckluft oder Trockeneis bei einem Gasdruck von 1 bis 20 bar ud einer Gasgeschwindigkeit von mindestens 2 m/s, um Siliciumstaub von den Bruchstücken zu entfernen, wobei keine chemische Nassreinigung erfolgt.

8. Verfahren nach Anspruch 7, wobei das polykristalline Silicium mit kontaminationsarmem Werkzeug in Bruchstücke gebrochen wird.

9. Verfahren nach einem der Ansprüche 7 oder 8 , wobei die Behandlung der Bruchstücke mit Druckluft oder Trockeneis für 0,01 bis 2000 Sekunden erfolgt.

10. Verfahren nach einem der Ansprüche 7 bis 9 , wobei die Bruchstücke mit Druckluft und Trockeneis behandelt werden, um Siliciumstaub von den Bruchstücken zu entfernen.

## Claims

1. Polycrystalline silicon containing polycrystalline silicon fragments, at least 90% of the fragments having a size from 10 to 40 mm, **characterized by** silicon dust particle contents of less than 15 ppmw for particle sizes of less than 400 µm, less than 14 ppmw for particle sizes of less than 50 µm, less than 10 ppmw for particle sizes of less than 10 µm and less than 3 ppmw for particle sizes of less than 1 µm, and furthermore **characterized by**
surface metal impurities greater than or equal to 0.1 ppbw and less than or equal to 100 ppbw.

2. Polycrystalline silicon containing polycrystalline silicon fragments, at least 90% of the fragments having a size from 20 to 60 mm, **characterized by** silicon dust particle contents of less than 15 ppmw for particle sizes of less than 400 µm, less than 14 ppmw for particle sizes of less than 50 µm, less than 10 ppmw for particle sizes of less than 10 µm and less than 3 ppmw for particle sizes of less than 1 µm, and furthermore **characterized by**
surface metal impurities greater than or equal to 0.1 ppbw and less than or equal to 100 ppbw.

3. Polycrystalline silicon containing polycrystalline silicon fragments, at least 90% of the fragments having a size greater than 45 mm, **characterized by** silicon dust particle contents of less than 15 ppmw for particle sizes of less than 400 µm, less than 14 ppmw for particle sizes of less than 50 µm, less than 10 ppmw for particle sizes of less than 10 µm and less than 3 ppmw for particle sizes of less than 1 µm, and furthermore **characterized by**
surface metal impurities greater than or equal to 0.1 ppbw and less than or equal to 100 ppbw.

4. Polycrystalline silicon containing polycrystalline silicon fragments, at least 90% of the fragments having a size from 3 to 15 mm, **characterized by** silicon dust particle contents of less than 45 ppmw for particle sizes of less than 400 µm, less than 30 ppmw for particle sizes of less than 50 µm, less than 20 ppmw for particle sizes of less than 10 µm and less than 10 ppmw for particle sizes of less than 1 µm, and furthermore **characterized by**
surface metal impurities greater than or equal to 0.1 ppbw and less than or equal to 1 ppmw.

5. Polycrystalline silicon containing polycrystalline silicon fragments, at least 90% of the fragments having a size from 0.5 to 5 mm, **characterized by** silicon dust particle contents of less than 70 ppmw for particle sizes of less than 400 µm, less than 62 ppmw for particle sizes of less than 50 µm, less than 60 ppmw for particle sizes of less than 10 µm and less than 40 ppmw for particle sizes of less than 1 µm, and furthermore **characterized by**
surface metal impurities greater than or equal to 0.1 ppbw and less than or equal to 10 ppmw.

6. Polycrystalline silicon according to one of Claims 1 to 5, wherein the metals of the surface impurities comprise Fe, Cr, Ni, Na, Zn, Al, Cu, Mg, Ti, W, K, Co and Ca.

7. Method for the production of polycrystalline silicon according to one of Claims 1 to 6, comprising fracture of polycrystalline silicon deposited on thin rods in a Siemens reactor into fragments, classification of the fragments into size classes of from about 0.5 mm to more than 45 mm and a subsequent treatment of the fragments by means of compressed air or dry ice at a gas pressure of from 1 to 20 bar and a gas speed of at least 2 m/s, in order to remove silicon dust from the fragments, without wet chemical cleaning.

8. Method according to Claim 7, wherein the polycrystalline silicon is broken into fragments with a low-contamination tool.

9. Method according to either of Claims 7 and 8, wherein the treatment of the fragments with compressed air or dry ice is carried out for from 0.01 to 2000 seconds.

10. Method according to one of Claims 7 to 9, wherein the fragments are treated with compressed air and dry ice, in order to remove silicon dust from the fragments.

## Revendications

1. Silicium polycristallin, contenant des fragments de silicium polycristallins, au moins 90 % des fragments ayant une taille de 10 à 40 mm, **caractérisé par** des fractions consistant en particules de poussière de silicium de moins de 15 ppm en poids pour les tailles de particules inférieures à 400 µm, de moins de 14 ppm en poids pour les tailles de particules inférieures à 50 µm, de moins de 10 ppm en poids pour les tailles de particules inférieures à 10 µm et de moins de 3 ppm en poids pour les tailles de particules inférieures à 1 µm, et en outre **caractérisé par** des contaminations superficielles avec des métaux supérieures ou égales à 0,1 ppb en poids et inférieures ou égales à 100 ppb en poids.

2. Silicium polycristallin, contenant des fragments de silicium polycristallins, au moins 90 % des fragments ayant une taille de 20 à 60 mm, **caractérisé par** des fractions consistant en particules de poussière de silicium de moins de 15 ppm en poids pour les tailles de particules inférieures à 400 µm, de moins de 14 ppm en poids pour les tailles de particules inférieures à 50 µm, de moins de 10 ppm en poids pour les tailles de particules inférieures à 10 µm et de moins de 3 ppm en poids pour les tailles de particules inférieures à 1 µm, et en outre **caractérisé par** des contaminations superficielles avec des métaux supérieures ou égales à 0,1 ppb en poids et inférieures ou égales à 100 ppb en poids.

3. Silicium polycristallin, contenant des fragments de silicium polycristallins, au moins 90 % des fragments ayant une taille de plus de 45 mm, **caractérisé par** des fractions consistant en particules de poussière de silicium de moins de 15 ppm en poids pour les tailles de particules inférieures à 400 µm, de moins de 14 ppm en poids pour les tailles de particules inférieures à 50 µm, de moins de 10 ppm en poids pour les tailles de particules inférieures à 10 µm et de moins de 3 ppm en poids pour les tailles de particules inférieures à 1 µm, et en outre **caractérisé par** des contaminations superficielles avec des métaux supérieures ou égales à 0,1 ppb en poids et inférieures ou égales à 100 ppb en poids.

4. Silicium polycristallin, contenant des fragments de silicium polycristallins, au moins 90 % des fragments ayant une taille de 3 à 15 mm, **caractérisé par** des fractions consistant en particules de poussière de silicium de moins de 45 ppm en poids pour les tailles de particules inférieures à 400 µm, de moins de 30 ppm en poids pour les tailles de particules inférieures à 50 µm, de moins de 20 ppm en poids pour les tailles de particules inférieures à 10 µm et de moins de 10 ppm en poids pour les tailles de particules inférieures à 1 µm, et en outre **caractérisé par** des contaminations superficielles avec des métaux supérieures ou égales à 0,1 ppb en poids et inférieures ou égales à 1 ppm en poids.

5. Silicium polycristallin, contenant des fragments de silicium polycristallins, au moins 90 % des fragments ayant une taille de 0,5 à 5 mm, **caractérisé par** des fractions consistant en particules de poussière de silicium de moins de 70 ppm en poids pour les tailles de particules inférieures à 400 µm, de moins de 62 ppm en poids pour les tailles de particules inférieures à 50 µm, de moins de 60 ppm en poids pour les tailles de particules inférieures à 10 µm et de moins de 40 ppm en poids pour les tailles de particules inférieures à 1 µm, et en outre **caractérisé par** des contaminations superficielles avec des métaux supérieures ou égales à 0,1 ppb en poids et inférieures ou égales à 10 ppm en poids.

6. Silicium polycristallin selon l'une quelconque des revendications 1 à 5, dans lequel les métaux des contaminations superficielles comprennent Fe, Cr, Ni, Na, Zn, Al, Cu, Mg, Ti, W, K, Co et Ca.

7. Procédé pour la production de silicium polycristallin selon l'une quelconque des revendications 1 à 6, comprenant le fractionnement en fragments de silicium polycristallin déposé sur des barres fines dans un réacteur Siemens, la classification des fragments en classes de tailles d'environ 0,5 mm à plus de 45 mm et un traitement subséquent des fragments par de l'air comprimé ou de la glace carbonique sous une pression de gaz de 1 à 20 bars et à une vitesse du gaz d'au moins 2 m/s, afin de séparer la poussière de silicium des fragments, aucun nettoyage chimique par voie humide n'étant effectué.

8. Procédé selon la revendication 7, dans lequel on fragmente le silicium polycristallin en fragments à l'aide d'un outil présentant peu de contamination.

9. Procédé selon la revendication 7 ou 8, dans lequel le traitement des fragments s'effectue avec de l'air comprimé ou de la glace carbonique pendant 0,01 à 2 000 secondes.

10. Procédé selon l'une quelconque des revendications 7 à 9, dans lequel on traite les fragments par de l'air comprimé et de la glace carbonique, pour séparer la poussière de silicium des fragments.
